# EUROPEAN PATENT APPLICATION

(11) **EP 2 023 382 A1**
(43) Date of publication of application: **11.02.2009**
(21) Application number: 07742708.6
(22) Date of filing: 30.04.2007
(51) Int. Cl.: H01L 21/3065, C23C 14/06, H01L 21/308, H01L 33/00

(54) **ETCHING METHOD, ETCHING MASK AND METHOD FOR MANUFACTURING SEMICONDUCTOR DEVICE USING THE SAME**

(30) Priority: 01.05.2006 JP 2006128016; 01.05.2006 JP 2006128023
(71) Applicant: Mitsubishi Chemical Corporation, Minato-ku Tokyo 108-0014 (JP)
(72) Inventor: HORIE, Hideyoshi, Ushiku-shi, Ibaraki 300-1295 (JP)
(74) Representative: Luderschmidt, Schüler & Partner
(86) International application number: PCT/JP2007/059273
(87) International publication number: WO 2007/126091

(57) **Abstract**

An etching method has the steps of forming a metal-fluoride layer at a temperature of 150 °C or higher at least as a part of an etching mask 3 formed over a semiconductor layer 2; patterning the metal-fluoride layer; and etching the semiconductor layer using the patterned metal-fluoride layer 3 as a mask. According to the etching method, an etching-resistant semiconductor layer such as a Group III-V nitride semiconductor can be easily etched by a relatively simpler process.

## Description

### Technical Field

The present invention relates to a method for etching a semiconductor and a process for manufacturing a semiconductor device using the method. In particular, it relates to an etching method suitably employed for manufacturing an electronic device and a light-emitting device using a GaN material such as light-emitting diode (LED).

### Background Art

Electron devices and light-emitting devices having a Group III-V compound semiconductor are well-known. In particular, there have been practically used as a light-emitting device an AlGaAs or AlGaInP material formed on a GaAs substrate for red luminescence and a GaAsP material formed on a GaP substrate for orange or yellow luminescence. An infrared light-emitting device using an InGaAsP material on a InP substrate is also known.

As the types of these devices, a light-emitting diode utilizing spontaneous emissive light (light-emitting diode: LED), a laser diode having an optical feedback function for deriving an induced emissive light (laser diode: LD) and a semiconductor laser are known. These devices have been used as, for example, a display device, a communication device, a light-source device for high-density optical recording, a device for high-precision optical processing and a medical device.

Since 1990s, as results of attempts for research and development of an InₓAl_{y}Ga_{(1-x-y)}N Group III-V compound semiconductor (0≤ x≤ 1, 0≤ y≤ 1, 0≤ x+y≤ 1) containing nitrogen as a Group V element, the emission efficiency of the devices using the same has been significantly improved, and blue and green LEDs with high efficiency have been realized. Subsequent research and development have led to LEDs with high efficiency even in the ultraviolet region and recently blue LEDs have been marketed.

By integrating a phosphor with an ultraviolet or blue LED as an excitation light source, a white LED can be obtained. Since a white LED may be utilized as a next-generation lighting device, improvement in output and efficiency in an ultraviolet or blue LED to be an excitation light source has considerably higher industrial significance. At present, intense attempts are made for improving efficiency and output in a blue or ultraviolet in the light of applications in LED lighting.

For improving an output in an element, that is, improvement of the total radiation flux, increase of an element size and ensuring resistance to a large input power are essential. In addition, a common LED is a point light source. If adequately enlarged, the element exhibits light-emitting properties as a plane light source, which becomes particularly suitable for illumination applications.

However, an element having geometrical similarity with simply enlarged area of a common small LED does not exhibit uniform emission intensity over the whole element in general. There has been thus proposed integration of LEDs on a single substrate. For example, Japanese Laid-open Patent Publication No. 1999-150303 (Patent Reference 1) has disclosed an integrated light-emitting unit in which individual LEDs are series-connected as a light-emitting unit suitable as a surface light source. Japanese Laid-open Patent Publication No. 2002-26384 (Patent Reference 2) has disclosed a process for LED integration for the purpose of providing an integrated nitride semiconductor light-emitting element with a large area and a higher light-emission efficiency. For integration, it is necessary to electrically separate a pair of pn junction as a single light-emitting unit from other light-emitting units, and, therefore, technique of forming an effective "trench" in a nitride semiconductor layer is quite essential.

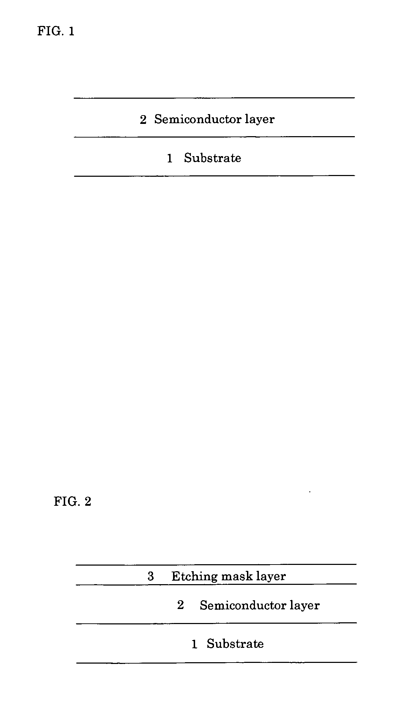

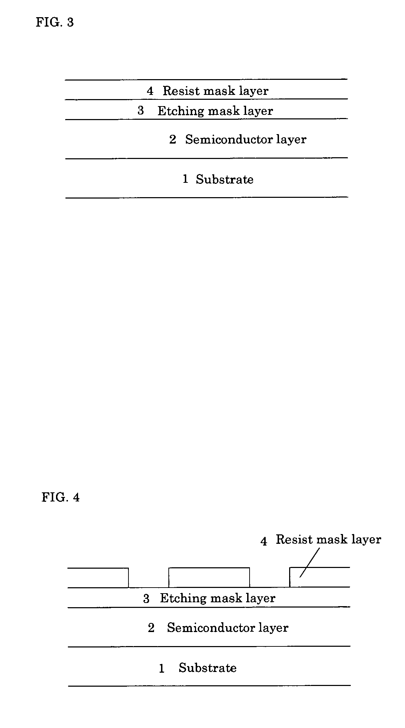

Japanese Laid-open Patent Publication No. 1999-150303 (Patent Reference 1) has disclosed that in order to separate a pair of pn junction, i.e. a single light-emitting unit, between units, a GaN layer is etched using an Ni mask until an insulative substrate is exposed (see, paragraph 0027 in Patent Reference 1). Furthermore, Japanese Laid-open Patent Publication No. 2002-26384 (Patent Reference 2) has disclosed that for separating a pair of pn junction as a single light-emitting unit from other light-emitting units, an inter-unit separation trench is formed by etching a GaN material using SiO₂ as a mask by RIE (reactive ion etching) until the etching reaches a sapphire substrate (see, FIG. 2, FIG. 3 and paragraph 0038 in Patent Reference 2).

However, a metal mask such as Ni used in Patent Reference 1, an oxide mask such as SiO₂ used in Patent Reference 2 and a known nitride mask such as SiN is insufficient in etching resistance and therefore insufficient in selection ratio as an etching mask for a GaN material. As a result, there has been difficulty in, for example, controlling an etching shape. As a practical problem, etching a thick GaN epitaxial layer having a thickness of several µm using an oxide mask such as SiO₂ requires an SiO₂ mask having an extremely large thickness, leading to poor productivity.

By the way, there has been proposed a fluoride mask in addition to the above metal, oxide and nitride masks.

For example, Journal of Vacuum Science and Technology B, Vol. 8, p.28, 1990 (Non-patent Reference 1) has described that an SrF₂ mask and an AlF₃ mask are formed by a lift-off method using a PMMA resist as masks for forming a separation trench in a GaN material, for etching an AlGaAs material and for conducting regrowth and further that an AlSrF mask is formed by a MBE method at room temperature. However, based on our investigation, a fluoride mask deposited at room temperature has insufficient properties. While it can work as an etching mask for a relatively easy-etching material such as an AlGaAs material, it is insufficiently resistant as an etching mask for a quite etching-resistant material such as a GaN material. A SrF₂ single-mask formed at room temperature has a problem of irregularity in its sidewall as described later.

Likewise, Japanese Laid-open Patent Publication No. 1994-310471 (Patent Reference 3) has disclosed that SrF₂ and AlF₃ formed by a lift-off method can be used for fine etching of a GaAs, InGaAs or InGaAsP material. Although this reference does not describe the conditions for depositing an etching mask, the mask is assumed to be formed at a mask deposition temperature from room temperature to at most about 100 °C, since the mask is patterned by a lift-off method using a resist susceptible to electron-beam exposure. As described above, a mask formed at about room temperature is insufficiently resistant as an etching mask for a GaN material and has a problem of irregularity in its sidewall.

Furthermore, Japanese Laid-open Patent Publication No. 1993-36648 (Patent Reference 4) has disclosed an approach that a GaAs material is etched using a metal or SrF₂ mask patterned by a lift-off method. Again, although this reference does not describe the conditions for depositing the SrF₂ mask, the mask is assumed to be formed at a mask deposition temperature from room temperature to at most about 100 °C since the mask is patterned by a lift-off method.

As described above, a metal-fluoride has been used as an etching mask for a Group III-V compound semiconductor such as GaAs, but it is unknown to use a metal-fluoride for a Group III-V nitride semiconductor such as GaN and to pattern a metal-fluoride layer by a method other than a lift-off method. In the prior art where a lift-off method is used for patterning a metal-fluoride, there has been a problem that the film properties of metal-fluoride is insufficient, and the freedom for the process conditions is low.
Patent Reference 1: Japanese Laid-open Patent Publication No. 1999-150303;
Patent Reference 2: Japanese Laid-open Patent Publication No. 2002-26384;
Patent Reference 3: Japanese Laid-open Patent Publication No. 1994-310471;
Patent Reference 4: Japanese Laid-open Patent Publication No. 1993-36648; and
Non-patent Reference 1: Journal of Vacuum Science and Technology B, Vol. 8, p.28, 1990.

### Disclosure of the Invention

### Subject to be solved by the Invention

In view of the problems in the prior art, an objective of the present invention is to provide a method for etching a semiconductor layer whereby an etching-resistant semiconductor layer such as a Group III-V nitride semiconductor can be easily etched by a relatively simpler process.

Another objective of the present invention is to provide an etching mask suitable for such an etching method.

Another objective of the present invention is to provide a process for manufacturing a semiconductor device, particularly a semiconductor light-emitting device having the above etching method as one step.
Means to solve the Subject

The present invention relates to a method for etching a semiconductor layer, comprising steps of:
providing a semiconductor layer,
forming a metal-fluoride layer at a temperature of 150 °C or higher at least as a part of an etching mask formed over the semiconductor layer,
patterning the metal-fluoride layer, and
etching the semiconductor layer using the patterned metal-fluoride layer as a mask.

The present invention also relates to an etching mask comprising a metal-fluoride layer formed at a temperature of 150 °C to 480 °C.

The present invention also relates to a method for etching a Group III-V nitride semiconductor layer, comprising steps of:
forming a metal-fluoride layer containing a bivalent or trivalent metal element as at least a part of an etching mask over the Group III-V nitride semiconductor layer,
patterning the metal-fluoride layer by wet etching, and
dry etching the Group III-V nitride semiconductor layer using the patterned metal-fluoride layer as a mask.

The present invention also relates to a semiconductor stacked structure, comprising
a Group III-V nitride semiconductor layer, and
an etching mask layer comprising a metal-fluoride layer formed at a temperature of 150 °C to 480 °C.

The present invention also relates to a process for manufacturing a semiconductor device comprising the above etching method as one step, as well as a semiconductor device manufactured by such a method.

### Effect of the Invention

According to the present invention, there can be provided a method for etching a semiconductor layer whereby an etching-resistant semiconductor layer such as a Group III-V nitride semiconductor can be easily etched by a relatively simple process.

According to another aspect of the present invention, there can be provided an etching mask suitable for such an etching method.

According to another aspect of the present invention, there can be provided a process for manufacturing a semiconductor device, particularly a semiconductor light-emitting device having the above etching method as one step.

### BRIEF DESCRIPTION OF THE DRAWINGS

FIG. 1 is a process cross-sectional view illustrating an etching method according to one embodiment.
FIG. 2 is a process cross-sectional view illustrating an etching method according to one embodiment.
FIG. 3 is a process cross-sectional view illustrating an etching method according to one embodiment.
FIG. 4 is a process cross-sectional view illustrating an etching method according to one embodiment.
FIG. 5 is a process cross-sectional view illustrating an etching method according to one embodiment.
FIG. 6 is a process cross-sectional view illustrating an etching method according to one embodiment.
FIG. 7 is a process cross-sectional view illustrating an etching method according to one embodiment.
FIG. 8 is a process cross-sectional view illustrating an etching method according to one embodiment.
FIG. 9 is a process cross-sectional view illustrating one embodiment in which an etching method of the present invention is applied to a semiconductor layer on whose surface a metal layer is formed.
FIG. 10 is a process cross-sectional view illustrating one embodiment in which an etching method of the present invention is applied to a semiconductor layer on whose surface a metal layer is formed.
FIG. 11 is a process cross-sectional view illustrating one embodiment in which an etching method of the present invention is applied to a semiconductor layer on whose surface a metal layer is formed.
FIG. 12 is a process cross-sectional view illustrating one embodiment in which an etching method of the present invention is applied to a semiconductor layer on whose surface a metal layer is formed.
FIG. 13 is a process cross-sectional view illustrating one embodiment in which an etching method of the present invention is applied to a semiconductor layer on whose surface a metal layer is formed.
FIG. 14 is a process cross-sectional view illustrating one simplified embodiment of etching a semiconductor layer on whose surface a metal layer is formed.
FIG. 15 is a process cross-sectional view illustrating one simplified embodiment of etching a semiconductor layer on whose surface a metal layer is formed.
FIG. 16 is a process cross-sectional view illustrating one simplified embodiment of etching a semiconductor layer on whose surface a metal layer is formed.
FIG. 17 is a process cross-sectional view illustrating one simplified embodiment of etching a semiconductor layer on whose surface a metal layer is formed.
FIG. 18 is a process cross-sectional view illustrating one simplified embodiment of etching a semiconductor layer on whose surface a metal layer is formed.

The symbols have the following meanings;
1: substrate,
2: semiconductor layer,
3: etching mask layer,
4: resist mask layer,
7: electrode,
8: electrode,
9: etching mask layer,
10: opening,
11: trench,
21: second etching mask (SiNx and so on),
22: metal-fluoride mask,
25: concave,
26: trench.

### Best Mode for Carrying Out the Invention

In the present application, the term, "stacked" or "overlap" may refer to, in addition to the state that materials are directly in contact with each other, the state that even when being not in contact with each other, one material spatially overlaps the other material when one is projected to the other, as long as it does not depart from the gist of the invention. The term, "over or on ···(under ···)" may also refer to, in addition to the state that materials are directly in contact with each other and one is placed on (under) the other, the state that even when being not in contact with each other, one is placed over (below) the other, as long as it does not depart from the gist of the invention. Furthermore, the term, "after ··· (before or prior to ···)" may be applied to not only the case where one event occurs immediately after (before) another event, but also the case where a third event intervenes between one event and another subsequent (preceding) event. The term, "contact" may refer to, in addition to the case where "materials are directly in contact with each other", the case where "materials are indirectly in contact with each other via a third member without being not directly in contact with each other" or where "a part where materials are directly in contact with each other and a part where they are indirectly in contact with each other via a third member are mixed" as long as it fits the spirit of the present invention. In addition, the term "numeric 1 to numeric 2" is used to mean a value equal to or more than numeric 1 and equal to or less than numeric 2.

Furthermore, in the present invention, "epitaxial growth" includes, in addition to formation of an epitaxial layer in a so-called crystal growth apparatus, subsequent carrier activation and the like of the epitaxial layer by, for example, heating, charged-particle treatment, plasma processing or the like.

### Section A

A first aspect of the present invention relates to the followings, which are described in Section A.
[1] A method for etching a semiconductor layer, comprising steps of:
   providing a semiconductor layer,
   forming a metal-fluoride layer at a temperature of 150 °C or higher at least as a part of an etching mask formed over the semiconductor layer,
   patterning the metal-fluoride layer, and
   etching the semiconductor layer using the patterned metal-fluoride layer as a mask.
[2] The method as described in [1], wherein the metal-fluoride layer is formed at a temperature of 480 °C or lower.
[3] The method as described in [1] or [2], wherein the metal-fluoride layer comprises a bivalent or trivalent metal element.
[4] The method as described in [3], wherein the metal-fluoride layer is selected from the group consisting of SrF₂, AlF₃, MgF₂, BaF₂, CaF₂ and combinations of these.
[5] The method as described in any one of [1] to [4], wherein the step of forming the metal-fluoride layer is conducted by vacuum evaporation.
[6] The method as described in any one of [1] to [5], wherein the step of etching the semiconductor layer is conducted by dry etching.
[7] The method as described in [6], wherein the dry etching is plasma excited dry etching using a gaseous species at least containing chlorine.
[8] The method as described in [7], wherein the chlorine-containing gaseous species is selected from the group consisting of Cl₂, BCl₃, SiCl₄, CCl₄ and combinations of two or more of these.
[9] The method as described in [7] or [8], wherein the plasma excitation in the dry etching is conducted by inductively-coupled excitation.
[10] The method as described in any one of [1] to [9], wherein the step of patterning the metal-fluoride layer is conducted by wet etching using a resist.
[11] The method as described in [10], wherein the etchant used in the wet etching contains an acid or alkali.
[12] The method as described in [11], wherein the etchant contains at least hydrochloric acid or hydrofluoric acid.
[13] The method as described in any one of [1] to [12], further comprising the step of removing the metal-fluoride layer after the step of etching the semiconductor layer.
[14] The method as described in [13], wherein the step of removing the metal-fluoride layer is conducted using an etchant containing an acid or alkali.
[15] The method as described in any one of [1] to [14], wherein the etching mask formed over the semiconductor layer comprises a portion of multilayer structure including the metal-fluoride layer and a second mask layer other than a metal-fluoride.
[16] The method as described in [15], wherein during the step of removing the metal-fluoride layer, the second mask layer is resistant to an etchant for removing the metal-fluoride layer.
[17] The method as described in [15] or [16], wherein the second mask layer is an oxide or nitride layer.
[18] The method as described in any one of [15] to [17], wherein the second mask layer is selected from the group consisting of silicon nitride, silicon oxide and a combination of these.
[19] The method as described in any one of [15] to [18], wherein the metal-fluoride layer is present as the surface of the etching mask, the second mask layer is present below the metal-fluoride layer and during the etching the semiconductor layer, the metal-fluoride layer works as an anti-etching layer.
[20] The method as described in [19], wherein the second mask layer is smaller than the metal-fluoride layer.
[21] The method as described in [19] or [20], wherein the second mask layer covers a metal layer.
[22] The method according to any one of [1] to [21], wherein the semiconductor layer comprises any one of:
   (i) a semiconductor substrate;
   (ii) a semiconductor layer in a stacked structure including the semiconductor layer and a substrate; or
   (iii) a semiconductor layer and a semiconductor substrate in a stacked structure including the semiconductor layer and the semiconductor substrate.
[23] The method as described in any one of [1] to [22], wherein concave-convex structure is formed on the semiconductor layer before forming the etching mask.
[24] An etching mask comprising a metal-fluoride layer formed at a temperature of 150 °C to 480 °C.
[25] The etching mask as described in [24], wherein the metal-fluoride layer is selected from the group consisting of SrF₂, AlF₃, MgF₂, BaF₂, CaF₂ and combinations of these.
[26] The etching mask as described in [24] or [25], wherein the metal-fluoride layer is formed by vacuum evaporation.
[27] The etching mask as described in any one of [24] to [26], used for dry etching.
[28] The etching mask as described in any one of [24] to [27], which can be patterned by wet etching.
[29] The etching mask as described in any one of [24] to [28], wherein the etching mask comprises a stacked portion including:
   the metal-fluoride layer, and
   an oxide layer and/or a nitride layer.
[30] A process for manufacturing a semiconductor device comprising the etching method as described in any one of [1] to [23] as one step.
[31] A semiconductor device manufactured by the manufacturing process as described in [30].

### Description of embodiments in Section A

An etching method according to the present invention comprises, as described above, the steps of providing a semiconductor layer, forming a metal-fluoride layer at a temperature of 150 °C or higher at least as a part of an etching mask formed over the semiconductor layer, patterning the metal-fluoride layer, and etching the semiconductor layer using the patterned metal-fluoride layer as an etching mask. The present invention will be described with reference to FIGs. 1 to 8 as appropriate.

### Semiconductor layer

There are no particular restrictions to a material for a semiconductor layer to be etched, which may be a semiconductor commonly used in a semiconductor device such as silicon, germanium, Group III-V compound semiconductors and II-VI compound semiconductors. A metal-fluoride etching mask of the present invention may be used for any semiconductor layer as long as it can be particularly etched by dry etching. Here, a metal-fluoride etching mask of the present invention is significantly resistant to dry etching, so that even when being applied to a semiconductor resistant to dry etching, it ensures a large etching selection ratio. Therefore, when used in such occasion, the effects of the present invention can be exerted at maximum.

There are also no restrictions to a method for forming a semiconductor layer and the present invention may be applied to a semiconductor layer formed by any method. A semiconductor layer in the present invention may be a semiconductor substrate itself, or a semiconductor layer formed on a substrate, or a combination of a semiconductor substrate and a semiconductor layer formed thereon. When the present invention is applied to manufacturing a light-emitting element, the semiconductor layer is preferably a layer formed on a substrate by thin film crystal growth technique such as epitaxial growth. Herein, the term, "thin film crystal growth" may refer to formation of a thin film layer, an amorphous layer, a microcrystal, a polycrystal, a single crystal or a stacked structure of these in a crystal growth apparatus by, for example, MOCVD (Metal Organic Chemical Vapor Deposition), MBE (Molecular Beam Epitaxy), plasma assisted MBE, PLD (Pulsed Laser Deposition), PED (Pulsed Electron Deposition), VPE (Vapor Phase Epitaxy) or LPE (Liquid Phase Epitaxy), including, for example, a subsequent carrier activating process of a thin film layer such as heating and plasma treatment.

A material for a semiconductor layer which is very useful and generally resistant to dry etching, that is, a semiconductor to which an etching mask of the present invention is suitably applied, preferably contains an element selected from In, Ga, Al, B and a combination of two or more of these as a constituent element; further preferably, the semiconductor layer contains nitrogen as a Group V element; most preferably, the semiconductor layer contains only nitrogen as a Group V element. The semiconductor layer may be specifically made of a Group III-V nitride semiconductor (hereinafter, sometimes referred to as "GaN-based semiconductor" for simplicity) such as GaN, InN, AlN, InGaN, AlGaN, InAlN, InAlGaN and InAlBGaN. These may, if necessary, contain an element such as Si and Mg as a dopant.

The present invention can also be suitably applied to etching of a semiconductor other than a Group III-V nitride semiconductor such as GaAs-based, GaP-based, InP-based and Si-based materials.

The semiconductor layer may have a multilayer structure and when the present invention is used for preparing a Group III-V nitride semiconductor (GaN-based material) light-emitting element, the semiconductor layer desirably contains, for example, a buffer layer, a first conductivity type cladding layer, a first conductivity type contact layer, an active layer structure, a second conductivity type cladding layer and a second conductivity type contact layer, which are grown by thin-film crystal growth (typically, epitaxial growth).

There will be described, as a typical example, a case where a semiconductor layer 2 formed over a substrate 1 is to be etched, as shown in FIG. 1, but this invention can be applied to a case where a substrate itself is a semiconductor layer to be dry-etched in the absence of a semiconductor layer 2 or where both substrate 1 and semiconductor layer 2 are semiconductor layers to be dry-etched.

There are no particular restrictions to a substrate on which a semiconductor layer is formed as long as it allows for forming a desired semiconductor layer; for example, semiconductor substrates and ceramic substrates, insulative substrates and conductive substrates, and transparent substrates and opaque substrates can be used. Preferably, it is appropriately chosen in the light of, for example, a desired semiconductor device and a manufacturing process for a semiconductor.

For example, when a GaN-based light-emitting element structure is prepared, it is desirably substantially optically transparent to an emission wavelength of an element. The term, "substantially transparent" as used herein, means no absorption to an emission wavelength or, if present, absorption by a substrate which reduces an optical output by less than 50 %. Furthermore, an electrically insulative substrate is preferable for manufacturing a GaN-based light-emitting element. It is because even if a solder material adheres to the periphery of the substrate assuming that so-called flip-chip mounting is conducted, it does not affect current injection into a semiconductor light-emitting device. Here, specific examples of the material is preferably selected from sapphire, SiC, GaN, LiGaO₂, ZnO, ScAlMgO₄, NdGaO₃ and MgO, particularly preferably sapphire, GaN and ZnO substrates for epitaxially growing an InAlGaN light-emitting material or an InAlBGaN material over the substrate. In particular, when a GaN substrate is used, its Si doping concentration is desirably a Si concentration of 3 × 10¹⁷ cm⁻³ or less for an undoped substrate, more desirably 1 × 10¹⁷ cm⁻³ or less in the light of electric resistance and crystallinity.

A substrate used in this invention is desirably, in addition to a just-substrate completely defined by a so-called plane index, a so-called off-substrate (miss oriented substrate) in the light of controlling crystallinity during epitaxial growth. An off-substrate is, when a semiconductor layer formed on it is an epitaxial layer, widely used as a substrate because it is effective for promoting favorable crystal growth in a step flow mode and thus effective for improving a morphology of a semiconductor layer. For example, when a c+ plane substrate of sapphire is used as a substrate for crystal growth of a GaN-based material, it is preferable to use a plane inclined to an m+ direction at an angle of about 0.2 °. An off-substrate having a small inclination of about 0.1 to 0.2 ° is generally used, but in a GaN-based material formed on sapphire, a relatively larger off-angle is possible for canceling an electric field due to piezoelectric effect to a quantum well layer as a light-emitting point within an active layer structure.

A substrate may be pretreated by chemical etching or heating for manufacturing a semiconductor layer utilizing crystal growth technique such as MOCVD and MBE. Alternatively, a substrate may be deliberately processed to have irregularity to prevent penetrating dislocation generated in an interface between an epitaxial layer and the substrate from being introduced near an active layer of a light-emitting element in a light-emitting unit described later. In this case, an etching mask layer is formed on concave-convex surface, but the present invention allows for an excellent etching mask layer even in such a case.

A thickness of the substrate is selected in the light of a desired semiconductor device and a semiconductor process, and is generally preferably, for example, about 250 to 700 µm in an initial stage of device preparation for ensuring mechanical strength during the element manufacturing process. After growing a semiconductor layer by sputtering, vapor deposition or epitaxial growth, it is desirable that for facilitating separation into individual elements, the substrate is appropriately thinned by a polishing step in the course of the process and in a particular embodiment, desirably has a final thickness of about 100 µm or less as a semiconductor element, particularly semiconductor light-emitting device.

### Deposition of a metal-fluoride layer

FIG. 2 shows a state after forming an etching mask layer 3 on a semiconductor layer 2. The etching mask layer contains at least one metal-fluoride layer.

A material for the metal-fluoride layer may be a fluoride of a bivalent or trivalent metal, particularly a fluoride of a metal element selected from Groups 2 (2A), 3 (3A), 12 (2B) and 13 (3B) in the long-form periodic table. Specific examples include SrF₂, CaF₂, MgF₂, BaF₂ and AlF₃, preferably SrF₂, CaF₂ and MgF₂ in the light of balance between dry etching resistance and wet etching properties, and among these, CaF₂ and SrF₂ are preferable, SrF₂ is the most preferable.

The present invention has been achieved based on the finding that film properties are improved and properties as an etching mask layer are significantly improved by depositing such a metal-fluoride, particularly a metal-fluoride selected from SrF₂, CaF₂, MgF₂, BaF₂, AlF₃ and combinations of these at a temperature of 150 °C or higher. In the description below, film deposition at a temperature of 150 °C or higher may be simply called "high-temperature film deposition". Furthermore, in the description of the present invention, the term, "metal-fluoride layer" generally means a metal-fluoride layer formed by high-temperature film deposition according to the present invention.

As described above, it has been proposed to use a metal-fluoride such as SrF₂ as an etching mask, but only a mask pattern deposited at about ambient temperature is known as it is formed by a lift-off method using a photoresist. However, a mask deposited at about ambient temperature has insufficient film properties, exhibits very poor adhesiveness to a semiconductor layer, and gives only a "rough" film.

Since high-temperature film deposition is employed in the present invention, a conventional lift-off method using a photoresist cannot be employed for patterning a metal-fluoride film. Thus, as detailed later, patterning by wet etching is preferably employed. Therefore, the metal-fluoride film is required to be adequately resistant to etching of a semiconductor layer (generally, dry etching) while being quite susceptible to etching for patterning (preferably, wet etching) and giving a patterning shape having good linearity, particularly in a sidewall. Furthermore, it is also important controllability in a width of an opening during the patterning. In a conventional film such as SrF₂ formed at about ambient temperature, linearity of a sidewall is not ensured in terms of a patterning shape by wet etching, irregularity is significant and controllability in a width of an opening is not ensured, so that it is definitely undesirable as a mask layer for etching a semiconductor layer.

In the present invention, deposition of a metal-fluoride layer at a temperature of 150 °C or higher gives a dense film having good adhesiveness to a base layer which shows good linearity in a mask sidewall after patterning by etching. A deposition temperature is preferably 250 °C or higher , further preferably 300 °C or higher , most preferably 350 °C or higher.
Particularly, a metal-fluoride layer deposited at 350 °C or higher exhibits good adhesiveness to any type of base layer and gives a fine film which is highly tolerant to dry etching and exhibits quite higher linearity in its sidewall in terms of a patterning shape, ensuring controllability to a width of the opening, and thus it is the most preferable as an etching mask.

Thus, deposition at a high temperature is preferable for providing an etching mask exhibiting good adhesiveness to a base layer, giving a dense film, being highly tolerant to dry etching and exhibiting very high linearity in its sidewall and very high controllability of a width of the opening in terms of a patterning shape. However, too high deposition temperature leads to excessive tolerance to an etchant in wet etching described later, and thus it may make the patterning using a photoresist or the removal difficult. Particularly, when a mask such as SrF₂ is exposed to plasma such as chlorine plasma during dry etching of a semiconductor layer as described later, an etching rate in a later process for removing the mask layer tends to be reduced in comparison with that before exposure to plasma such as chlorine plasma. Therefore, deposition of a metal-fluoride at an excessively higher temperature is undesirable in the light of its patterning and final removal.

First, in a metal-fluoride before being exposed to plasma in dry etching of a semiconductor layer, a layer deposited at a lower temperature has a larger etching rate to an etchant such as hydrochloric acid, resulting in a higher etching rate and a layer deposited at a higher temperature has a smaller etching rate, resulting in a lower etching rate. When deposition temperature becomes 300 °C or higher, the etching rate decreases noticeably in comparison with a film deposited at a temperature of about 250 °C, and a temperature of about 350 °C to 450 °C is within a very favorable etching rate range. A deposition temperature of higher than 480 °C, however, leads to an excessively smaller absolute etching rate value, so that patterning of the metal-fluoride layer takes a too longer time and patterning may be difficult under the conditions where a resist mask layer and so on are not detached. Furthermore, in a metal-fluoride after being exposed to plasma in dry etching of a semiconductor layer, a wet-etching rate by, for example, hydrochloric acid in a removal step tends to decrease and growth at an excessively high temperature makes it difficult to remove the metal-fluoride which becomes unneeded after etching of the semiconductor layer.

Furthermore, deposition of a metal-fluoride at an excessively elevated temperature gives excessive heat history to a substrate, a semiconductor layer or a metal layer formed on the semiconductor layer as described later, and thus a mask formation process may adversely affect a device during manufacturing process of a semiconductor light-emitting element and the like.

From such a viewpoint, a deposition temperature of a metal-fluoride layer is preferably 480 °C or lower, further preferably 470 °C or lower, particularly preferably 460 °C or lower.

Under the conditions of etching a semiconductor layer, an etching selection ratio of a metal-fluoride layer to a semiconductor layer is 40 or more, preferably 200 or more, more preferably 400 or more, which can be also applied to a Group III-V nitride semiconductor.

The metal-fluoride layer can be formed by a common film deposition method such as sputtering, electron beam vapor evaporation and vacuum evaporation. However, sputtering or electron beam vapor evaporation may give an etching mask with a low selection ratio. This would be because electrons or ions directly collide a fluoride to possibly dissociate the fluoride into a metal and fluorine depending on the conditions. Therefore, in these film deposition methods, the deposition conditions must be properly selected, leading to restrictions to the manufacturing conditions. On the other hand, vacuum evaporation using, for example, resistance heating does not have such a problem and, therefore, is the most desirable. Even a vapor deposition method using electron beam is desirable like the resistance heating method if indirect heating is employed, for example, by heating a crucible containing a material by electron beam rather than direct irradiation of a fluoride material with electron beam. By these vapor deposition methods, a metal-fluoride layer exhibiting good dry etching resistance can be easily deposited.

A deposition rate of a metal-fluoride layer such as SrF₂ is preferably within a range of about 0.05 nm/sec to 3 nm/sec, further preferably of about 0.1 nm/sec to 1 nm/sec. A metal-fluoride layer deposited at a rage within this range is more desirable because it becomes a film exhibiting good adhesiveness to the base layer and ensuring plasma resistance.

In the present invention, the etching mask layer may be a single layer film of a metal-fluoride layer or a multilayer film of these, or alternatively a multilayer structure in combination with a second mask layer other than a metal-fluoride layer. In the present invention, it is just required that a metal-fluoride layer is exposed in a surface to able to protect the structure below during etching of the semiconductor layer. Therefore, another layer may be formed in the semiconductor layer side, for the purpose of protection of a semiconductor or a component formed on a semiconductor or other. In one embodiment of the present invention, for example, as described later, also preferable is a multilayer film which has a film of, for example, SiNₓ or SiOₓ as a second mask layer formed under the metal-fluoride layer for preventing removal of a metal layer formed on a semiconductor layer when the metal-fluoride layer is finally removed. Furthermore, in addition to the second mask layer formed under the metal-fluoride layer, for example, a third mask layer may be formed over the metal-fluoride layer. These can be appropriately selected, depending on a purpose.

### Patterning of a metal-fluoride layer

In the present invention, a metal-fluoride layer deposited at a high temperature is patterned into a desired shape, preferably by etching. This etching of a metal-fluoride layer is conducted under the conditions allowing a metal-fluoride to be etched and different from the etching conditions for a semiconductor layer; in particular, wet etching using an acid or alkali.

It is preferable that another mask is used for patterning an etching mask layer containing a metal-fluoride layer. For example, as shown in FIG. 3, a resist mask layer 4 from a photoresist material is formed on an etching mask layer 3, and the resist mask layer 4 is patterned as shown in FIG. 4 by a common photolithographic procedure such as exposure and development.

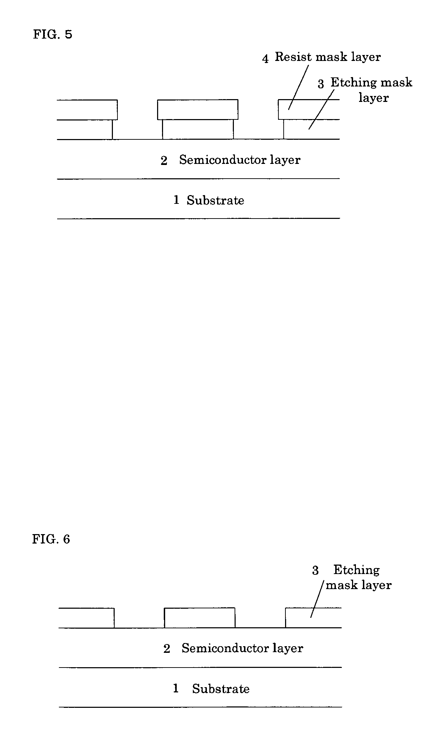

In the present invention, it is desirable that the etching mask layer 3 containing a metal-fluoride layer is then etched using the patterned resist mask layer 4 as a mask to transfer the pattern as shown in FIG. 5.

An etchant for the wet etching may be preferably an aqueous solution containing an acid such as hydrochloric acid, hydrofluoric acid, sulfuric acid, phosphorous acid and nitric acid, if necessary, further containing an oxidizing agent such as hydrogen peroxide and/or a diluent such as ethylene glycol. Although being selected taking a material for the metal-fluoride layer and the deposition conditions into account, the etchant particularly preferably contains at least hydrochloric acid or hydrofluoric acid; for example, hydrochloric acid is desirable for patterning SrF₂ while hydrofluoric acid is desirable for patterning CaF₂. The etching may be conducted using an alkali, and any etching may be combined with light irradiation, heating or the like.

After completing wet etching of the etching mask layer 3 and forming the structure shown in FIG. 5 as described above, a resist mask layer 4 which becomes unneeded is generally removed to obtain a structure where the patterned etching mask layer 3 is formed on the semiconductor layer as shown in FIG. 6.

### Etching of a semiconductor layer

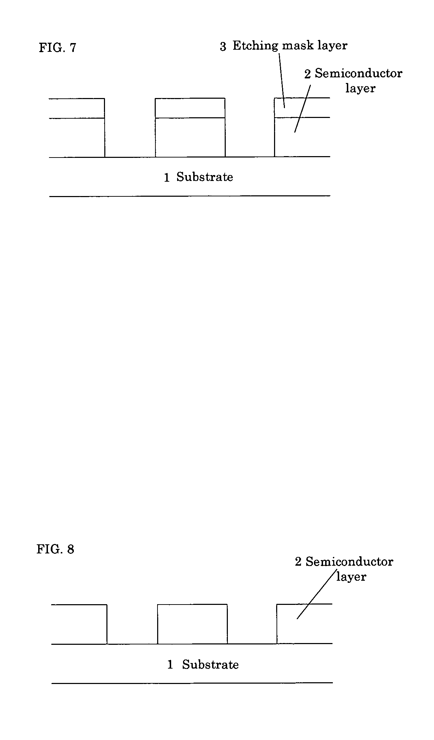

In the step of etching a semiconductor layer, the semiconductor layer 2 is etched using the etching mask layer 3 as a mask as shown in FIG. 7.

A semiconductor layer is etched desirably by dry etching. In dry etching, the conditions such as a gaseous species, a bias power and a degree of vacuum can be appropriately selected, depending on the properties of the semiconductor layer such as a material and crystallinity. When the semiconductor layer is a Group III-V nitride semiconductor, a gaseous species for the dry etching is desirably selected from Cl₂, BCl₃, SiCl₄, CCl₄ and combinations of these. Chlorine-containing plasma generated from these gaseous species allows for a large selection ratio between a GaN-based material and a metal-fluoride material deposited at a high temperature in the dry etching, and thus a nitride semiconductor layer can be etched without substantially etching the high-temperature deposited metal-fluoride material. As a result, the semiconductor layer can be etched with excellent shape controllability. During the dry etching, a thickness of the metal-fluoride layer is little reduced, but film properties, particularly its resistance to wet etching tends to vary, leading to reduction in a wet etching rate.

During the dry etching, a plasma can be generated by any procedure such as capacity-coupled plasma generation (CCP type), inductively-coupled plasma generation (ICP type) and plasma generation based on electron cyclotron resonance (ECR type). However, in the present invention, it is desirable to generate chlorine-containing plasma by inductively-coupled plasma generation. This is because the approach can obtain a higher plasma density than that in any other approach, which is advantageous in etching a Group III-V nitride semiconductor material or the like. Here, a plasma density during the dry etching is preferably 0.05×10¹¹ (cm⁻³) to 10.0×10¹¹ (cm⁻³), more preferably 1×10¹¹ (cm⁻³) to 7.0×10¹¹ (cm⁻³). Furthermore, a metal-fluoride layer deposited at a high temperature in the present invention has so improved etching resistance that it can exhibit adequate resistance even to a plasma with a high plasma density formed by an inductive connection method.

For example, a selection ratio of a mask to a nitride semiconductor layer is about 5 to 20 when using a nitride or oxide such as SiNₓ and SiOₓ or metal such as Ni as a mask. On the other hand, a metal-fluoride mask of the present invention can give a selection ratio of 100 or more even to a nitride semiconductor layer. Therefore, the method of the present invention is particularly preferably used for deeply etching a Group III-V nitride semiconductor layer. For a Group III-V nitride semiconductor layer, the present invention can be applied to an etching depth of 1 µm or more, preferably 2 µm or more, more preferably 3 µm or more, most preferably 5 µm or more, even more than 10 µm. Furthermore, if an adequately thick SrF₂ mask is formed before the etching of the semiconductor layer, a very thick layer can be etched although it depends on a material for the metal-fluoride mask, a thickness and a material for the semiconductor layer. A thickness of the semiconductor layer to be etched is generally 50 mm or less, preferably 35 mm or less, more preferably 5 mm or less, further preferably 1 mm or less, most preferably 500 µm or less. As examples of etching of an extremely thick semiconductor layer, there are exemplified a case where a thick GaN substrate with a thickness of about 3 mm to 35 mm is etched using an SrF₂ mask and a case where most of the thickness of the substrate and thin-film crystal growth layers of a GaN epitaxial layer and the like grown on the substrate are simultaneous etched. It is, of course, possible that only a thin-film crystal growth layer with a thickness of about 7 µm is etched without the substrate being etched. In such a case, a large selection ratio allows for reducing a trench width formed by etching as appropriate; for example, it may be reduced to 100 µm or less, preferably 10 µm or less, further preferably 3 µm or less. An aspect ratio of a trench depth to a trench opening width (depth/width) can be appropriately selected; even for a Group III-V nitride semiconductor layer, the aspect ratio of 0.1 or more, preferably 2 or more is possible, and up to about 50, for example, up to about 30 is possible.

An etching depth of the semiconductor layer in the present invention can be appropriately selected, and although FIG. 7 shows a case where the semiconductor layer is totally etched to the substrate, the semiconductor layer may be etched to its middle and a part of the substrate, which may be a non-semiconductor material such as sapphire, may be continuously etched by varying an etching gaseous species or the like. The extent of the etching or a layer constituting the semiconductor layer to which the etching reaches can be appropriately selected.

After completing etching of the semiconductor layer as shown in FIG. 7, if necessary, the etching mask layer may be removed, or a different process may be initiated while retaining the etching mask layer. Generally, it is preferable to remove the etching mask layer.

FIG. 8 shows a structure after removing the etching mask layer 3. Any method may be employed for removing a metal-fluoride layer constituting the etching mask layer 3; for example, the metal-fluoride layer may be removed by an etchant containing an acid or alkali. In the afore-mentioned step of patterning a metal-fluoride layer, the conditions are selected such that a metal-fluoride is easily etched while a semiconductor layer is resistant to etching. Here, in the step of removing the metal-fluoride layer, similar conditions to those in the patterning step may be employed.

An etchant for the wet etching may be, therefore, preferably an aqueous solution containing an acid such as hydrochloric acid, hydrofluoric acid, sulfuric acid, phosphorous acid and nitric acid, if necessary, further containing an oxidizing agent such as hydrogen peroxide and/or a diluent such as ethylene glycol. Although being selected taking a material for the metal-fluoride layer and the deposition conditions into account, the etchant particularly preferably contains at least hydrochloric acid or hydrofluoric acid; for example, hydrochloric acid is desirable for removing SrF₂ while hydrofluoric acid is desirable for removing CaF₂. The removal may be conducted using an alkali, and any etching may be combined with light irradiation, heating or the like for accelerating the reaction or improving selectivity.

For a metal-fluoride layer, a wet etching rate tends to decrease, that is, solubility in an etchant tends to be reduced after it is used as a mask layer during dry etching of the semiconductor layer; and thus, the conditions of the whole process are preferably determined, taking this fact into account.

Although an unneeded etching mask layer is removed as described above, the etching mask layer may be used, for example, as a mask for selective growth instead of being removed, to form a further semiconductor layer. In particular, when epitaxial growth is conducted, a metal-fluoride material such as SrF₂ may be also used as a mask for selective growth.

### Description of another embodiment

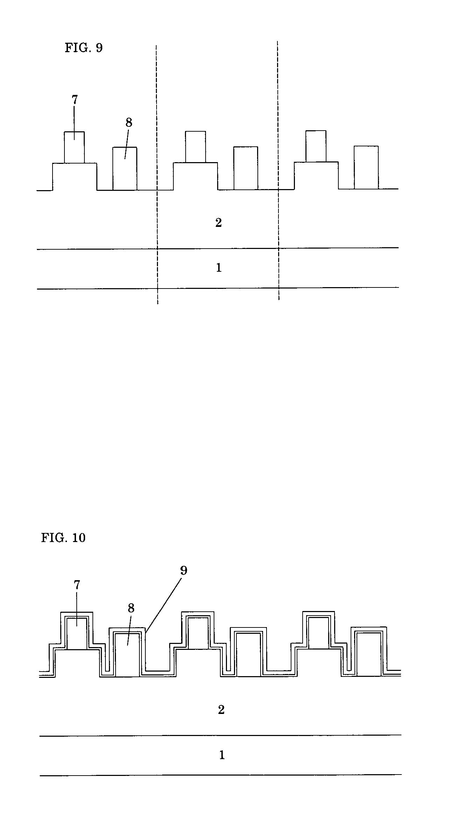

There will be described one particular embodiment of the present invention. In this embodiment, an etching method of the present invention is applied to a structure where, as shown in FIG. 9, the semiconductor layer 2 over the substrate 1 already has a step and then electrodes 7 and 8 of a metal layer are formed over the semiconductor layer.

When a semiconductor layer having a metal layer such as an electrode and an interconnection made of, for example, aluminum is etched by the etching method of the present invention, removal of a metal-fluoride after completion of the etching may lead to erosion and removal of the metal layer such as an electrode and an interconnection by an etchant containing an acid or alkali. In such a case, it is preferable that the etching mask layer has a multilayer structure having a metal-fluoride layer and a second mask layer other than a metal-fluoride, and that the surface of the semiconductor layer having a metal layer is covered by the second mask layer which is resistant to an etchant and formed of other than a metal-fluoride layer. The second mask layer must be removed under the conditions where a metal layer is not eroded. Examples of the second mask layer include an oxide such as SiOₓ, AlOₓ, TiOₓ, TaOₓ, HfOₓ and ZrOₓ; a nitride such as SiNₓ and AlNₓ; and combination of these. These are very preferable because they are wet-etching resistant while being finally removable by dry etching by which a metal is not etched. SiNₓ and SiOₓ are particularly preferable because they can be relatively easily manufactured, especially SiNₓ.

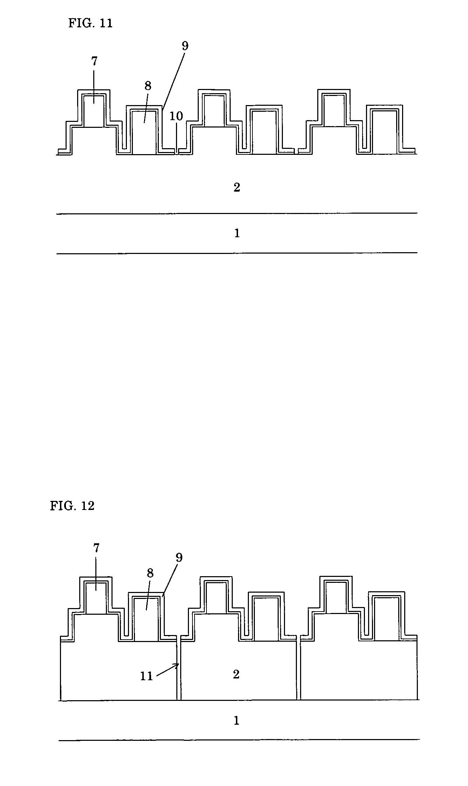

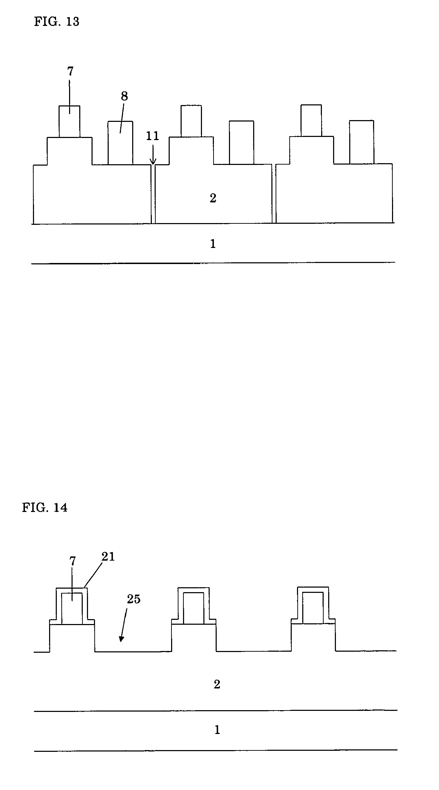

FIG. 10 shows a state where an etching mask layer 9 having a multilayer structure of a layer other than a metal-fluoride such as SiNₓ and metal-fluoride layers are formed, in this order from the side of the semiconductor layer, on the semiconductor layer 2 having metal layers (electrodes 7,8). When the semiconductor layer 2 is dry etched, the superficial metal-fluoride layer functions as a mask as shown in FIGs. 11 and 12. Then, for removing the etching mask layer 9, first the metal-fluoride layer is removed by an acid or alkali while the electrodes 7, 8 made of, for example, aluminum are protected by the second mask layer other than a metal-fluoride such as SiNₓ. Then, the layer other than a metal-fluoride such as SiNₓ can be removed by dry etching without the metal layer being eroded, to give the structure shown in FIG. 13.

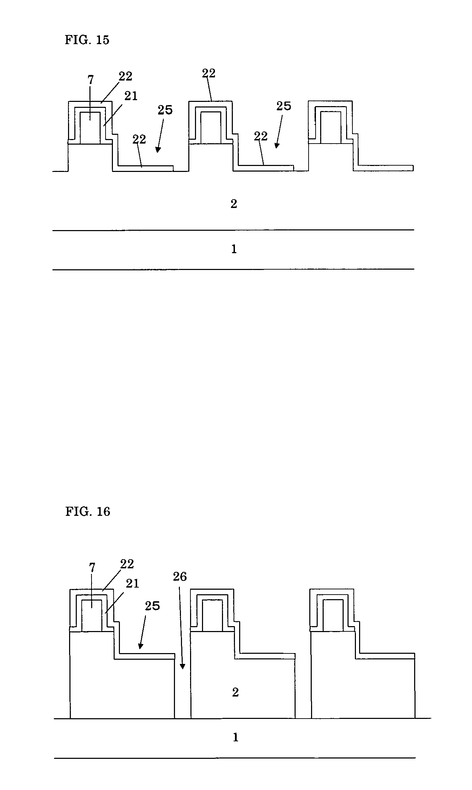

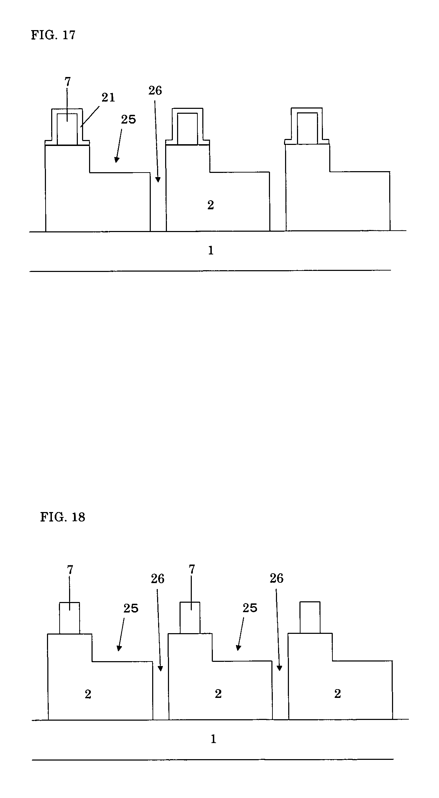

In the above case, only a part of the etching mask layer, for example, the part upper the metal layer (for example, electrodes 7, 8) may be formed as a multilayer structure while the part upper the portion other than the metal layer may be formed as a single layer. Furthermore, a multilayered etching mask layer may be used in any step in the manufacturing process of a semiconductor device; it is particularly desirably used in the light of consistency of the whole process.
There will be illustrated an example where etching is conducted using an etching mask partially having a multilayer structure in consideration with process consistency. First, FIG. 14 shows the state where a second etching mask 21 made of a mask material other than a metal-fluoride is formed and the semiconductor layer 2 formed over the substrate 1 is etched to form a concave 25. The second etching mask 21 is made of, for example, SiNₓ, masking an area including a metal layer (electrode 7). An area which is not covered by the second etching mask 21 is etched to form a concave 25. Even when the semiconductor layer 2 is made of a material resistant to etching such as GaN, a known mask material such as SiNₓ may be satisfactorily used in the etching when the concave 25 is shallow.
Next, when deep etching is conducted using the metal-fluoride layer as a mask, a metal-fluoride mask 22 is formed without removing the second etching mask 21 as shown in FIG. 15. Thus, the semiconductor layer surface over the metal layer (electrode 7) and its adjacent area have a two-layer structure of the metal-fluoride mask and the second etching mask.
Then, as shown in FIG. 16, the semiconductor layer 2 is deeply etched using the metal-fluoride mask 22 as a mask to form a trench 26. As described above, a metal-fluoride layer is resistant to dry etching, and therefore deep etching is possible. Next, the metal-fluoride mask 22 is removed by, for example, an acid to leave the second etching mask 21 as shown in FIG. 17. Thus, the metal layer is not eroded during removal of the metal-fluoride mask 22 by wet etching. Finally, the second etching mask 21 is removed by such a method that the metal layer (electrode 7) or the semiconductor layer is not damaged, whereby providing a structure having a shallow concave 25 and a deep trench 26 in the semiconductor layer 2 as shown in FIG. 18. Such a method may be selected depending on, for example, a material for the semiconductor layer and a material for the metal layer; for example, when the surface of the metal layer is made of Al, the semiconductor layer is a GaN layer and the second etching mask is made of SiNₓ, it is preferable to conduct dry etching such as reactive ion etching using a fluorine-containing gas as a reactive gas. Thus, in a manufacturing process for a semiconductor device including a first etching step of shallowly etching a semiconductor layer and a second etching step of deeply etching the semiconductor layer, the manufacturing process may be simplified while effectively protecting a metal layer by conducting etching using the second mask other than a metal-fluoride as a mask in the first etching step and then, without removing the mask, forming a metal-fluoride mask layer over the surface in the second etching step to provide a multilayer structure over a partial or the whole area.

Furthermore, in the present invention, forming of a metal-fluoride layer by vacuum evaporation, particularly a method employing heating such as resistance heating without directly colliding charged particles such as electrons and plasma is preferable because dissociation of the metal material and fluorine is prevented, and for further improving step coverage, particularly sidewall coverage, it is also preferable to employ a multilayer structure as described above as an etching mask layer.

For example, an oxide or nitride layer formed by plasma CVD exhibits excellent sidewall coverage for a substrate having a step. Examples of such a layer include oxides such as SiOₓ, AlOₓ, TiOₓ, TaOₓ, HfOₓ and ZrOₓ; nitrides such as SiNₓ and AlNₓ; and combinations of these. In the light of relatively easier production, SiNₓ and SiOₓ are particularly preferable, especially SiNₓ.

As described above, forming an etching mask layer as a multilayer structure of a metal-fluoride layer and a layer other than a metal-fluoride layer is preferable in the light of both protection of a metal layer and step coverage. In particular, taking process consistency into account, a partially multilayered mask can be employed to simplify a manufacturing process while protecting a metal layer.

The etching method of the present invention as described above may be applied to manufacturing a variety of semiconductor devices and can be used in the etching step in the semiconductor manufacturing process.

As described above, an etching mask of the present invention is significantly compatible to etching methods and semiconductor manufacturing processes.

### Section B

A second aspect of the present invention relates to the followings, which are described in Section B.

### Disclosed aspects in Section B

[1] A method for etching a Group III-V nitride semiconductor layer, comprising steps of:
   forming a metal-fluoride layer as at least a part of an etching mask over the Group III-V nitride semiconductor layer,
   patterning the metal-fluoride layer by etching, and
   etching the Group III-V nitride semiconductor layer using the patterned metal-fluoride layer as a mask.
[2] The method as described in [1], wherein
   the metal-fluoride layer contains a bivalent or trivalent metal element,
   the step of patterning the metal-fluoride layer is conducted by wet etching, and
   the step of etching the Group III-V nitride semiconductor layer is conducted by dry etching.
[3] The method as described in [2], wherein the metal-fluoride layer is selected from the group consisting of SrF₂, AlF₃, MgF₂, BaF₂, CaF₂ and combinations of these.
[4] The method as described in [2] or [3], wherein the step of forming the metal-fluoride layer is conducted by vacuum evaporation.
[5] The method as described in any one of [2] to [4], wherein the dry etching is plasma excited dry etching using a gaseous species at least containing chlorine.
[6] The method as described in [5], wherein the chlorine-containing gaseous species is selected from the group consisting of Cl₂, BCl₃, SiCl₄, CCl₄ and combinations of two or more of these.
[7] The method as described in [5] or [6], wherein the plasma excitation in the dry etching is conducted by inductively-coupled excitation.
[8] The method as described in any one of [2] to [7], wherein the metal-fluoride layer is formed at a temperature of 150 °C to 480 °C.
[9] The method as described in any one of [2] to [9], wherein the step of patterning the metal-fluoride layer comprises substeps of:
   forming a patterned photoresist film on the metal-fluoride layer by photolithography; and
   wet etching the metal-fluoride layer using the patterned photoresist film as a mask and an acid or alkali-containing etchant.
[10] The method as described in [9], wherein the etchant contains hydrochloric acid or hydrofluoric acid.
[11] The method as described in any one of [2] to [10], further comprising the step of removing the metal-fluoride layer by an acid- or alkali-containing etchant after the step of etching the Group III-V nitride semiconductor layer.
[12] The method as described in any one of [2] to [11], wherein the etching mask formed over the Group III-V nitride semiconductor comprises a portion of multilayer structure including the metal-fluoride layer and a second mask layer, which is formed of a material other than a metal-fluoride, and which is resistant to an etchant used in the step of removing the metal-fluoride layer, and the metal-fluoride layer works as an anti-etching layer during dry etching.
[13] The method as described in [12], wherein the second mask layer is an oxide or nitride layer.
[14] The method as described in [12] or [13], wherein the second mask layer is selected from the group consisting of silicon nitride, silicon oxide and a combination of these.
[15] The method as described in any one of [12] to [14], wherein the second mask layer is smaller than the metal-fluoride layer.
[16] The method as described in any one of [12] to [15], wherein the second mask layer covers a metal layer.
[17] The method as described in any one of [1] to [16], wherein concave-convex structure is formed on the Group III-V nitride semiconductor layer before forming the etching mask.
[18] A semiconductor stacked structure, comprising
   a Group III-V nitride semiconductor layer, and
   an etching mask layer having a metal-fluoride layer formed at a temperature of 150 °C to 480 °C.
[19] The semiconductor stacked structure as described in [18], wherein the etching mask layer consists of the metal-fluoride layer alone.
[20] The semiconductor stacked structure as described in [18], wherein the etching mask layer comprises a portion of multilayer structure of the metal-fluoride layer and an oxide or nitride layer formed under and in contact with the metal-fluoride layer.
[21] The semiconductor stacked structure as described in any one of [18] to [20], wherein the etching mask layer is patterned.
[22] The semiconductor stacked structure as described in any one of [18] to [21], wherein the metal-fluoride layer is selected from the group consisting of SrF₂, AlF₃, MgF₂, BaF₂, CaF₂ and combinations of these.
[23] A manufacturing process for a semiconductor device, comprising a step of forming a trench in a Group III-V nitride semiconductor layer by the method as described in any one of [1] to [17].
[24] A semiconductor device manufactured by the manufacturing process as described in [23].

According to the above invention, there can be provided a novel method for etching a Group III-V nitride semiconductor layer. This invention achieves apparently inconsistent properties of relatively easier wet etching and good dry-etching resistance by taking advantage of the characteristics of a metal-fluoride layer containing a bivalent or trivalent metal element, and therefore, the use of this process increases freedom in the conditions of forming a metal-fluoride layer, so that film quality can be appropriately adjusted in accordance with the conditions of the processes such as dry etching and wet etching.

Particularly, according to one aspect of this invention, a high film-quality layer which is resistant to dry etching can be formed, so that a Group III-V nitride semiconductor layer can be easily dry etched by a relatively simpler process. This invention is, therefore, preferably used in a manufacturing process for a semiconductor device having the step of forming a fine structure such as a fine trench (for example, a deep trench with a small width) in a Group III-V nitride semiconductor layer.

### Description of an embodiment in Section B

In the invention described in Section B, a Group III-V nitride semiconductor layer is to be etched. A material for the Group III-V nitride semiconductor layer is a Group III-V compound semiconductor in which a main component of Group V atoms is nitrogen. Of Group V atoms, ratio of nitrogen is preferably 90 % (atomic %) or more, more preferably 95 % or more, particularly preferably 98 % or more, most preferably 100 %. The higher the nitrogen content is, the more difficult etching of the Group III-V nitride semiconductor layer is. However, in the present invention, an etching mask exhibiting higher etching resistance is used to allow etching to be conducted with a large selection ratio. As Group III elements, are preferably contained an element selected from the group consisting of In, Ga, Al, B and combinations of these two or more. Specific examples include Group III-V nitride semiconductors (hereinafter, sometimes referred to as "GaN-based semiconductor" for simplicity) such as GaN, InN, AlN, InGaN, AlGaN, InAlN, InAlGaN and InAlBGaN. These may, if necessary, contain an element such as Si and Mg as a dopant.

There are no restrictions to a method for forming a Group III-V nitride semiconductor layer, and this invention can be applied to a semiconductor layer formed by any method (see Section A). The Group III-V nitride semiconductor layer may have a multilayer structure, and desirably contains a buffer layer, a first conductivity type cladding layer, a first conductivity type contact layer, an active layer structure, a second conductivity type cladding layer, a second conductivity type contact layer and the like formed by thin-film crystal growth (typically, epitaxial growth), when a Group III-V nitride semiconductor (GaN-based) light-emitting element is prepared using the present invention.

As shown in FIG. 1, this invention is typically applied to a case where the Group III-V nitride semiconductor layer 2 formed over the substrate 1 is to be etched, but can be also applied a case where the layer 2 is not present and a substrate itself is a Group III-V nitride semiconductor layer to be dry-etched, a case where both substrate 1 and layer 2 are a Group III-V nitride semiconductor layer to be dry-etched, and a case where although the substrate 1 is not a Group III-V nitride semiconductor layer, the layer 2 is a Group III-V nitride semiconductor layer and both substrate 1 and the layer 2 are etched. A substrate in the case where a Group III-V nitride semiconductor layer is formed over the substrate is as described in Section A.

In Section B, an etching object is a Group III-V nitride semiconductor layer. And for a metal-fluoride layer used as a mask to be compatible to a process of the present invention, for example, it must have proper (generally higher) solubility in an etchant used in the step of patterning a metal-fluoride layer such that the metal-fluoride material exposed in an opening of a patterning mask should be etched in a practical time period before the patterning mask used in the etching is detached or damaged. At the same time, the metal-fluoride layer must be practically etching-resistant in comparison with a Group III-V nitride semiconductor in the step of dry etching the Group III-V nitride semiconductor layer. There are, therefore, no particular restrictions to a metal-fluoride layer containing a bivalent or trivalent metal element as long as it has physical properties suitable for such a process, and materials and deposition conditions are selected such that such physical properties are obtained.
In the invention related to Section B, for example, embodiments and preferable ranges for a material for a metal-fluoride layer and manufacturing conditions and a subsequent manufacturing process are as described in Section A. In addition, the invention related to Section B is as described in Section A as long as there are no contradictions to the above disclosure.
Particularly, the etching method of this invention can be preferably used in the step of etching for forming a trench in a Group III-V nitride semiconductor layer in the manufacturing process for a semiconductor device.

The semiconductor stacked structure of the present invention having a Group III-V nitride semiconductor layer and an etching mask layer containing a metal-fluoride layer formed at a temperature of 150 °C to 480 °C appears in the course of the above etching method, and is substantially useful as an intermediate member in manufacturing a semiconductor device having a fine structure such as a fine and deep trench.

### EXAMPLES

There will be described the present invention with reference to examples. Materials, amounts, proportions, specific processes and process orders in the following examples may be appropriately modified without departing from the scope of the invention. The scope of this invention should not be interpreted to be limited to the specific examples described below. Furthermore, in the drawings referred in the following examples, some sizes are deliberately changed for more clearly understanding the structures, but practical dimensions are as indicated in the following description.

### Example 1

On an Si-doped GaN semiconductor layer grown on a sapphire substrate by MOCVD was vacuum-evaporated an SrF₂ film at various substrate temperatures by resistance heating. The SrF₂ film thus formed was scrutinized for properties for dry etching of a GaN layer, such as patterning properties as an etching mask, resistance during dry etching and wet etching properties during a subsequent removal process.

The SrF₂ film after deposition was patterned by wet etching at room temperature by an etchant of a 1:10 (by volume) mixture of hydrochloric acid (hydrogen chloride content: 36 %) and water using a resist mask, and the etching rate, linearity of the sidewall in the SrF₂ film pattern formed and controllability of an absolute value of an opening width were evaluated. Furthermore, the SrF₂ mask thus patterned was used for dry etching of the Si-doped GaN layer by Cl₂ plasma, and the SrF₂ mask was evaluated for compatibility during dry etching. Furthermore, for an etchant containing hydrochloric acid (hydrogen chloride content: 36 %) and water (1:10 by volume), an etching rate at room temperature during the removal step was determined for the SrF₂ film subjected to dry etching history by chlorine plasma of the Si-doped GaN semiconductor layer.

Furthermore, during depositing SrF₂, in the same chamber was placed a sample in which on the Si-doped GaN semiconductor layer was formed a Ti/Al/Au metal film on which was further formed an SiNₓ film, and resistance of the metal electrode part to heat history and change in the surface state during SrF₂ mask formation were observed. The metal surface state was observed after forming the SrF₂ film, removal of the SrF₂ film and removal of the SiNₓ film.

Table 1 shows the etching rates observed and the evaluation results.

### Table 1

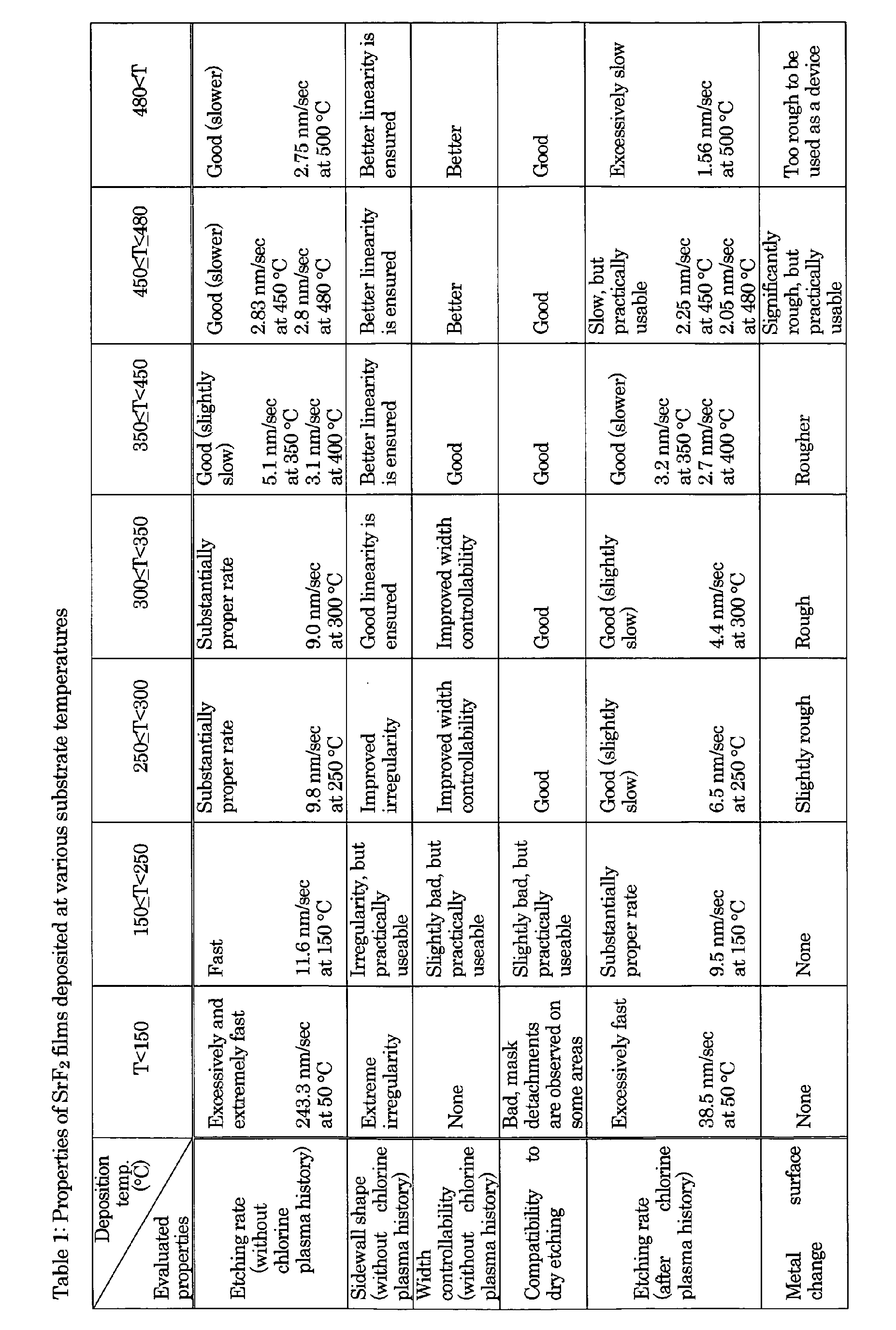

Table 1 shows that an SrF₂ film deposited at a substrate temperature of 150 °C or higher is suitable as an etching mask for dry etching. Furthermore, it can be understood that an SrF₂ film deposited at a substrate temperature of 480 °C or lower is preferable in the light of removal of the SrF₂ film at a practical rate after dry etching and the case where there is a metal layer as an underlying layer.

### Example 2

With reference to FIGs. 1 to 8, there will be described an example where an inter-element separation trench is formed in a semiconductor layer constituting a semiconductor light-emitting device by etching.

First, was prepared a c+ plane sapphire substrate 1 with a thickness of 430 µm, on which was formed a semiconductor layer 2 as described below. By MOCVD were formed an undoped GaN layer with a thickness of 10 nm grown at a low temperature as a first buffer layer and then an undoped GaN layer with a thickness of 1 µm at 1040 °C as a second buffer layer. Then, an Si-doped (Si concentration: 1×10¹⁸ cm⁻³) GaN layer was formed to a thickness of 2 µm as a first conductivity type (n-type) second cladding layer, an Si-doped (Si concentration: 2×10¹⁸ cm⁻³) GaN layer was formed to a thickness of 0.5 µm as a first conductivity type (n-type) contact layer, and an Si-doped (Si concentration: 1.5×10¹⁸ cm⁻³) Al_{0.15}Ga_{0.85}N layer was formed to a thickness of 0.1 µm as a first conductivity type (n-type) first cladding layer. Furthermore, an active layer structure was formed by depositing alternately undoped GaN layer to a thickness of 13 nm at 850 °C as a barrier layer and undoped In_{0.1}Ga_{0.9}N layer to a thickness of 2 nm at 720 °C as a quantum well layer, such that five quantum well layers in total were formed and both sides were barrier layers. Subsequently, at a growth temperature of 1025 °C was formed an Mg-doped (Mg concentration: 5×10¹⁹ cm⁻³) Al_{0.15}Ga_{0.85}N layer to a thickness of 0.1 µm as a second conductivity type (p-type) first cladding layer. Continuously, was formed an Mg-doped (Mg concentration: 5×10¹⁹ cm⁻³) GaN layer to a thickness of 0.05 µm as a second conductivity type (p-type) second cladding layer. Finally, was formed an Mg-doped (Mg concentration: 1×10²⁰ cm⁻³) GaN layer to a thickness of 0.02 µm as a second conductivity type (p-type) contact layer.

Then, after gradually lowering the temperature of the MOCVD growth oven, the wafer was taken out and thus thin film crystal growth was completed to prepare the structure shown in FIG. 1 after forming the semiconductor layer.

Then, as shown in FIG. 2, was formed an SrF₂ single layer as an etching mask layer 3 to a thickness of 400 nm by vacuum evaporation at 450 °C at a vapor deposition rate of 0.2 nm/sec. Next, as shown in FIG. 3, a resist mask layer 4 was formed by spin coating and then a resist pattern was formed by photolithography. Then, for patterning the etching mask layer 3 (SrF₂ monolayer) using a resist pattern 4, the wafer was immersed in an etchant of 1:10 (by volume) hydrochloric acid (hydrogen chloride content: 36 %) and water for 240 sec to etch the SrF₂ layer as shown in FIG. 5. The etched SrF₂ layer had good linearity, was free from unintended detachment and maintained high adherence. Then, the resist layer was removed as shown in FIG. 6 by acetone and oxygen plasma ashing to expose the SrF₂ layer as an etching mask. Then, the whole semiconductor epitaxial layer in a part corresponding to an inter-element separation trench was etched using inductively-coupled chlorine plasma as shown in FIG. 7. During the dry etching, despite the fact that the thick (average: 3.868 µm) GaN-based material with a thickness of more than 3.8 µm was dry-etched, the SrF₂ layer was little etched. Finally, as shown in FIG. 8, the wafer was immersed in an etchant of 1: 10 (by volume) hydrochloric acid/water for 300 sec for completely removing the unneeded SrF₂ layer, to complete formation of a trench for inter-element separation in a semiconductor light-emitting device. The inter-element separation trench prepared had a width of 100 µm.

### Example 3

Another example will be described with reference to FIGs. 1 and 9 to 12. First, was prepared a c+ plane sapphire substrate 1 with a thickness of 430 µm, on which was formed a semiconductor layer 2 as described below. By MOCVD were formed an undoped GaN layer with a thickness of 20 nm grown at a low temperature as a first buffer layer and then an undoped GaN layer with a thickness of 1 µm at 1040 °C as a second buffer layer 2. Continuously, an Si-doped (Si concentration: 1×10¹⁸ cm⁻³) GaN layer was formed to a thickness of 2 µm as a first conductivity type (n-type) second cladding layer, an Si-doped (Si concentration: 2×10¹⁸ cm⁻³) GaN layer was formed to a thickness of 0.5 µm as a first conductivity type (n-type) contact layer, and an Si-doped (Si concentration: 1.5×10¹⁸ cm⁻³) Al_{0.15}Ga_{0.85}N layer was formed to a thickness of 0.1 µm as a first conductivity type (n-type) first cladding layer. Furthermore, an active layer structure was formed by depositing alternately undoped GaN layer to a thickness of 13 nm at 850 °C as a barrier layer and undoped In_{0.13}Ga_{0.87}N layer to a thickness of 2 nm at 715 °C as a quantum well layer, such that three quantum well layers in total were formed and both sides were barrier layers. Subsequently, at a growth temperature of 1025 °C was formed an Mg-doped (Mg concentration: 5×10¹⁹ cm⁻³) Al_{0.15}Ga_{0.85}N layer to a thickness of 0.1 µm as a second conductivity type (p-type) first cladding layer. Continuously, was formed an Mg-doped (Mg concentration: 5×10¹⁹ cm⁻³) GaN layer to a thickness of 0.05 µm as a second conductivity type (p-type) second cladding layer. Finally, was formed an Mg-doped (Mg concentration: 1×10²⁰ cm⁻³) GaN layer to a thickness of 0.02 µm as a second conductivity type (p-type) contact layer.

Then, after gradually lowering the temperature of the MOCVD growth oven, the wafer was taken out and thus thin film crystal growth was completed (the structure in FIG. 1).

An etching mask was formed for conducting the first etching step of exposing the first conductivity type (n-type) contact layer in the semiconductor stacked structure after completion of the epitaxial growth. Here, over the whole surface of the semiconductor layer was formed an SrF₂ layer by vacuum evaporation at a substrate temperature of 200 °C and a vapor deposition rate of 0.5 nm/sec. Then, a photoresist pattern was formed on the SrF₂ layer by photolithography and the SrF₂ layer was partially etched for patterning by hydrochloric acid to prepare a first etching mask. Next, as a first etching step, inductively-coupled plasma using BCl₃ gas was used to etch the active layer structure consisting of the p-GaN contact layer, the p-GaN second cladding layer, the p-AlGaN first cladding layer, the active layer of the InGaN quantum well layer and the GaN barrier layer, the n-AlGaN first cladding layer and the intermediate portion of the n-GaN contact layer, to expose an n-type contact layer to be an injection part for n-type carrier.

After completion of plasma etching by inductively-coupled plasma, the whole SrF₂ mask layer was removed by hydrochloric acid. Here, the SrF₂ mask deposited at a substrate temperature of 200 °C was a mask exhibiting good linearity during patterning, which was little etched by plasma etching and exhibited good resistance to chlorine-containing plasma etching.

Next, over the thus-formed step was formed, by photolithography, a resist pattern for patterning a p-side electrode 7 by a lift-off method. As a metal layer A for forming a p-side electrode 7, Pd and Au were deposited to 20 nm and 1000 nm, respectively, by vacuum evaporation, and then an unneeded part was removed in acetone by a lift-off method. Then, a p-side electrode was formed after heat treatment (formation of the p-side electrode 7 in FIG. 9). Thus, since the p-side electrode 7 was formed without using, for example, a plasma process, a p-side current injection region was not damaged.

Then, a further resist pattern was formed, by photolithography, for patterning an n-side electrode 8 by a lift-off method. Here, over the whole surface of the wafer was formed Ti (thickness: 20 nm)/Al (thickness: 1500 nm) as a metal layer for forming an n-side electrode by vacuum evaporation, and the unneeded part was removed in acetone by a lift-off method. Then, an n-side electrode 8 was formed by heating (formation of the n-side electrode 8 in FIG. 9).

After the above process, the structure in FIG. 9 was formed.

Subsequently, for forming an etching mask layer 9 as a multilayer film of an SiNₓ and an SrF₂ films, the SiNₓ film was first formed to a thickness of 200 nm by p-CVD at a deposition temperature of 400 °C. Then, at an elevated temperature of 400 °C, the SrF₂ layer mask was formed to a thickness of 400 nm. Here, the SrF₂ mask was formed by vapor deposition at a rate of 0.5 nm/sec while a dome equipped with a sample was rotated and revolved, to provide the configuration in FIG. 10.

Then, for separation between light-emitting units, photolithography was used to form a photoresist pattern having an opening in an area for forming a separation trench, and the resist mask was used for wet etching of the etching mask layer 9 having a stacked structure of SrF₂ and SiNₓ to form an opening 10. The SrF₂ layer was selectively etched for 240 sec using an etchant of hydrochloric acid (hydrogen chloride content: 36 %):water=1:10 by volume, and then the SiNₓ layer was selectively etched for 3 min using an etchant of 1:5 (by volume) hydrofluoric acid : ammonium fluoride. Thus, there was provided a patterned etching mask layer in which both SrF₂ and SiNₓ parts exhibited good linearity and adhesiveness (FIG. 11).

Then, in the structure of FIG. 11, the semiconductor layer 2 was dry-etched by inductively-coupled plasma excitation using Cl₂ gas from the opening in the etching mask layer 9, to form a separation trench 11. During the etching, the multilayer mask used as an etching mask was little etched (FIG. 12).

Finally, the wafer was immersed in hydrochloric acid for 5 min to completely remove the SrF₂ part. Here, the SiNₓ mask part was not etched at all. Therefore, the electrode layer was not damaged by hydrochloric acid. Then, for removing the unneeded SiNₓ mask, the SiNₓ mask was removed by reactive etching using SF₆ gas for 1 min, to provide the configuration in FIG. 13.

Then, elements were cut out along the trench formed for inter-element separation to provide a light-emitting device.

### Industrial Applicability

The etching method of the present invention is useful for precisely etching a semiconductor layer, particularly a Group III-V nitride semiconductor layer such as GaN.

## Claims

1. A method for etching a semiconductor layer, comprising steps of:
providing a semiconductor layer,
forming a metal-fluoride layer at a temperature of 150 °C or higher at least as a part of an etching mask formed over the semiconductor layer,
patterning the metal-fluoride layer, and
etching the semiconductor layer using the patterned metal-fluoride layer as a mask.

2. The method according to Claim 1, wherein the metal-fluoride layer is formed at a temperature of 480 °C or lower.

3. The method according to Claim 1 or 2, wherein the metal-fluoride layer comprises a bivalent or trivalent metal element.

4. The method according to Claim 3, wherein the metal-fluoride layer is selected from the group consisting of SrF₂, AlF₃, MgF₂, BaF₂, CaF₂ and combinations of these.

5. The method according to any one of Claims 1 to 4, wherein the step of forming the metal-fluoride layer is conducted by vacuum evaporation.

6. The method according to any one of Claims 1 to 5, wherein the step of etching the semiconductor layer is conducted by dry etching.

7. The method according to Claim 6, wherein the dry etching is plasma excited dry etching using a gaseous species at least containing chlorine.

8. The method according to Claim 7, wherein the chlorine-containing gaseous species is selected from the group consisting of Cl₂, BCl₃, SiCl₄, CCl₄ and combinations of two or more of these.

9. The method according to Claim 7 or 8, wherein the plasma excitation in the dry etching is conducted by inductively-coupled excitation.

10. The method according to any one of Claims 1 to 9, wherein the step of patterning the metal-fluoride layer is conducted by wet etching using a resist.

11. The method according to Claim 10, wherein the etchant used in the wet etching contains an acid or alkali.

12. The method according to Claim 11, wherein the etchant contains at least hydrochloric acid or hydrofluoric acid.

13. The method according to any one of Claims 1 to 12, further comprising the step of removing the metal-fluoride layer after the step of etching the semiconductor layer.

14. The method according to Claim 13, wherein the step of removing the metal-fluoride layer is conducted using an etchant containing an acid or alkali.

15. The method according to any one of Claims 1 to 14, wherein the etching mask formed over the semiconductor layer comprises a portion of multilayer structure including the metal-fluoride layer and a second mask layer other than a metal-fluoride.

16. The method according to Claim 15, wherein during the step of removing the metal-fluoride layer, the second mask layer is resistant to an etchant for removing the metal-fluoride layer.

17. The method according to Claim 15 or 16, wherein the second mask layer is an oxide or nitride layer.

18. The method according to any one of Claims 15 to 17, wherein the second mask layer is selected from the group consisting of silicon nitride, silicon oxide and a combination of these.

19. The method according to any one of Claims 15 to 18, wherein the metal-fluoride layer is present as the surface of the etching mask, the second mask layer is present below the metal-fluoride layer and during the etching the semiconductor layer, the metal-fluoride layer becomes an anti-etching layer.

20. The method according to Claim 19, wherein the second mask layer is smaller than the metal-fluoride layer.

21. The method according to any one of Claims 19 to 21, wherein the second mask layer covers a metal layer.

22. The method according to any one of Claims 1 to 21, wherein the semiconductor layer comprises any one of:
(i) a semiconductor substrate;
(ii) a semiconductor layer in a stacked structure including the semiconductor layer and a substrate; or
(iii) a semiconductor layer and a semiconductor substrate in a stacked structure including the semiconductor layer and the semiconductor substrate.

23. The method according to any one of Claims 1 to 22, wherein concave-convex structure is formed on the semiconductor layer before forming the etching mask.

24. An etching mask comprising a metal-fluoride layer formed at a temperature of 150 °C to 480 °C.

25. The etching mask according to Claim 24, wherein the metal-fluoride layer is selected from the group consisting of SrF₂, AlF₃, MgF₂, BaF₂, CaF₂ and combinations of these.

26. The etching mask according to Claim 24 or 25, wherein the metal-fluoride layer is formed by vacuum evaporation.

27. The etching mask according to any one of Claims 24 to 26, used for dry etching.

28. The etching mask according to any one of Claims 24 to 27, which can be patterned by wet etching.

29. The etching mask according to any one of Claims 24 to 28, wherein the etching mask comprises a stacked portion including:
the metal-fluoride layer, and
an oxide layer and/or a nitride layer.

30. A process for manufacturing a semiconductor device comprising the etching method according to any one of Claims 1 to 23 as one step.

31. A semiconductor device manufactured by the manufacturing process according to Claim 30.

32. A method for etching a Group III-V nitride semiconductor layer, comprising steps of:
forming a metal-fluoride layer as at least a part of an etching mask over the Group III-V nitride semiconductor layer,
patterning the metal-fluoride layer by etching, and
etching the Group III-V nitride semiconductor layer using the patterned metal-fluoride layer as a mask.

33. The method according to Claim 32, wherein
the metal-fluoride layer contains a bivalent or trivalent metal element,
the step of patterning the metal-fluoride layer is conducted by wet etching, and
the step of etching the Group III-V nitride semiconductor layer is conducted by dry etching.

34. The method according to Claim 33, wherein the metal-fluoride layer is selected from the group consisting of SrF₂, AlFa, MgF₂, BaF₂, CaF₂ and combinations of these.

35. The method according to Claim 33 or 34, wherein the step of forming the metal-fluoride layer is conducted by vacuum evaporation.

36. The method according to any one of Claims 33 to 35, wherein the dry etching is plasma excited dry etching using a gaseous species at least containing chlorine.

37. The method according to Claim 36, wherein the chlorine-containing gaseous species is selected from the group consisting of Cl₂, BCl₃, SiCl₄, CCl₄ and combinations of two or more of these.

38. The method according to Claim 36 or 37, wherein the plasma excitation in the dry etching is conducted by inductively-coupled excitation.

39. The method according to any one of Claims 33 to 38, wherein the metal-fluoride layer is formed at a temperature of 150 °C to 480 °C.

40. The method according to any one of Claims 33 to 39, wherein the step of patterning the metal-fluoride layer comprises substeps of:
forming a patterned photoresist film on the metal-fluoride layer by photolithography; and
wet etching the metal-fluoride layer using the patterned photoresist film as a mask and an acid- or alkali-containing etchant.

41. The method according to Claim 40, wherein the etchant contains hydrochloric acid or hydrofluoric acid.

42. The method according to any one of Claims 33 to 41, further comprising the step of removing the metal-fluoride layer by an acid- or alkali-containing etchant after the step of etching the Group III-V nitride semiconductor layer.

43. The method according to any one of Claims 33 to 42, wherein the etching mask formed over the Group III-V nitride semiconductor comprises a portion of multilayer structure including the metal-fluoride layer and a second mask layer, which is formed of a material other than a metal-fluoride, and which is resistant to an etchant used in the step of removing the metal-fluoride layer, and the metal-fluoride layer works as an anti-etching layer during dry etching.

44. The method according to Claim 43, wherein the second mask layer is an oxide or nitride layer.

45. The method according to Claim 43 or 44, wherein the second mask layer is selected from the group consisting of silicon nitride, silicon oxide and a combination of these.

46. The method according to any one of Claims 43 to 45, wherein the second mask layer is smaller than the metal-fluoride layer.

47. The method according to any one of Claims 43 to 46, wherein the second mask layer covers a metal layer.

48. The method according to any one of Claims 32 to 47, wherein concave-convex structure is formed on the Group III-V nitride semiconductor layer before forming the etching mask.

49. A semiconductor stacked structure, comprising
a Group III-V nitride semiconductor layer, and
an etching mask layer having metal-fluoride layer formed at a temperature of 150 °C to 480 °C.

50. The semiconductor stacked structure according to Claim 49, wherein the etching mask layer consists of the metal-fluoride layer alone.

51. The semiconductor stacked structure according to Claim 49, wherein the etching mask layer comprises a portion of multilayer structure of the metal-fluoride layer and an oxide or nitride layer formed under and in contact with the metal-fluoride layer.

52. The semiconductor stacked structure according to any one of Claims 49 to 51, wherein the etching mask layer is patterned.

53. The semiconductor stacked structure according to any one of Claims 49 to 52, wherein the metal-fluoride layer is selected from the group consisting of SrF₂, AlF₃, MgF₂, BaF₂, CaF₂ and combinations of these.

54. A manufacturing process for a semiconductor device, comprising a step of forming a trench in a Group III-V nitride semiconductor layer by the method according to any one of Claims 32 to 48.

55. A semiconductor device manufactured by the manufacturing process according to Claim 54.
